# EUROPEAN PATENT APPLICATION

(11) **EP 3 144 686 A1**
(43) Date of publication of application: **22.03.2017**
(21) Application number: 15380038.8
(22) Date of filing: 18.09.2015
(51) Int. Cl.: G01R 19/155, G01R 29/12

(54) **PERSONAL PROTECTOR DEVICE AND METHOD FOR DETECTING ELECTRIC FIELDS AND/OR VOLTAGE**

(71) Applicant: Sofamel, SL, 08787 La Pobla de Claramunt (Barcelona) (ES)
(72) Inventor: PRAT GILI, Franc, 08700 Igualada (Barcelona) (ES); PALACIOS PÉREZ, Xavier, 08788 Vilanova del Camí (Barcelona) (ES)
(74) Representative: Juncosa Miro, Jaime

(57) **Abstract**

The device being used as a safety element against electrical shock hazard and comprising a housing holding an electric circuit (10), provided with acquisition means (12) for acquiring measuring signals of a detected electric field and alarm means (11) whereby a warning signal is generated. There have furthermore been provided a movement measuring element (14) for measuring the movement of the protective device and a control unit (13) connected to said electric circuit (10), which performs processing of the acquired electric field measuring signals and calculation of the variation experienced by the personal protective device (10) with respect to said detected electric field.

## Description

### Field of the invention

The present invention relates generally to the sector of devices for measuring electric fields and/or voltage. The invention particularly relates to a personal protective device for detecting electric fields and/or voltage, for example, of the type used in jobs involving an electrical hazard that can be found in most operations performed in medium- and high-voltage electrical installations. In said cases, the proposed device operates as a safety device against possible accidents due to electric arcs or shocks from a live physical point to a nearby operator. The personal protective device can be worn by a user in a protective helmet, for example.

The invention also relates to a method which comprises implementing a detection and warning strategy using the personal protective device as a safety element against electrical shock hazards.

### Background of the invention

Various protective devices are known today for detecting voltage and/or electric fields which are intended for personal use and can be used as safety elements for operators in the event of incidents in the form of electrical shock accidents, particularly in medium- and high-voltage electric current distribution substations.

Devices existing on the market measure the electric field and generate a warning signal if it exceeds a predetermined threshold.

This functionality does not allow the user to be completely safe from electrical shock hazards because an electric field can be very strong for two reasons:
- a high-voltage generator located far away from an operator;
- a low-voltage generator located nearby.

Taking into account that the electric field is by definition the ratio between voltage and distance, a field meter alone is not capable of discriminating between a high-voltage generator located far way or a low-voltage generator located nearby with respect to the operator, because the result of the ratio can be the same in the two circumstances and it may be dangerous in one case and not dangerous in another. Some of the known protective devices are therefore not effective.

Another common feature of the existing detectors is directionality. There are preferred directions and blind directions in terms of detection capacity. Blind directions can cause dangerous situations for the user, particularly when such directions point to the back of the operator to be protected.

Therefore, omni-directionality in detection is a feature that would significantly increase user safety.

Patent application EP1296150 discloses a portable electric field detector having a housing mountable on a user and including a sensing circuit responsive to an electric field to generate a signal which varies in proportion to the strength of the detected electric field, and an alarm circuit coupled to the detection circuit for producing an intermittent alarm signal with a repetition rate varying in proportion to the strength of the electric field.

Patent document JP-B2-3421826 discloses a charge detector provided for being installed on the wrist of an operator. The detector comprises a detector body incorporating a circuit for detecting a microcurrent electrostatically induced in a human body when the latter approaches a charged part of a high-voltage machine housed in a metallic housing through a first capacitance formed between the charged part and a detection electrode and a second capacitance formed between the human body and the earth. Likewise, the detector circuit also includes a circuit generating an alarm signal based on a detection signal.

Finally, utility model CN2172479 discloses a safety helmet for high-voltage line operators, which has incorporated therein an alarm system, consisting of an audible message to keep operators out of the danger zone. Said system is activated by the induction of the electric field and the electronic components forming it.

An object of the invention is to provide therefore a personal protective device for detecting electric fields and/or voltage, said device being located away from live electrical equipment or systems, being omni-directional and having a safety indication, preventing the drawbacks of earlier detectors and offering additional structural and operative advantages.

### Brief Description of the Invention

In a first aspect, the invention relates to a personal protective device for detecting electric fields and/or voltage of the type used as a safety element against electrical hazards which comprises, like detectors known in the state of the art, a housing holding an electric circuit provided for being incorporated on a user to be protected and preferably incorporated in a protective helmet of the user, and the mentioned electric circuit including acquisition means for acquiring electric field measuring signals responsive to the variation in strength of a detected electric field and alarm means (or element/module/device/unit) whereby a warning signal is generated.

Unlike the known proposals, the personal protective device further comprises at least one movement measuring element for measuring the movement of the mentioned personal device. Likewise, the mentioned electric circuit is connected to a control unit, such as a programmable integrated circuit or microcontroller, for processing the variation experienced by the personal protective device with respect to the detected electric field.

In a preferred embodiment, the acquisition means for acquiring electric field measuring signals include two capacitive sensors acting in parallel, each including at least one charge amplifier and a step of conditioning the acquired electric field measuring signals.

Alternatively, in a simpler embodiment the acquisition means comprise only one capacitive sensor and one charge amplifier.

The capacitive sensor or sensors can be sized to be responsive to different electric field values.

In the proposed personal protective device, the mentioned control unit can receive information about the movement of the personal protective device and control the actuation of the mentioned alarm means depending on the variation in the electric field and on the movement.

Likewise, the alarm means can be acoustic means, visual means, vibrating means, or a combination thereof.

In a preferred embodiment, the movement measuring element comprises at least one accelerometer.

According to a second aspect, the present invention also relates to a method for detecting electric fields and/or voltage which comprises using a personal protective device as a safety element against electrical hazards, wherein the mentioned personal protective device comprises an electric circuit including acquisition means for acquiring electric field measuring signals responsive to the variation in strength of a detected electric field, and alarm means whereby a warning signal is generated.

Unlike the known solutions, the proposed method is characterized in that it calculates a variation in the electric field experienced by the personal protective device incorporated on a user and contemporaneously measures any movement of the personal device, as a result of a movement of said user.

In one embodiment, the calculation of the variation in the electric field is performed continuously.

In one embodiment, the calculation of the variation in the electric field and the measurement of movement are performed in the personal device itself. Alternatively, said calculation can be performed in a computing device located away from the personal device, the computing device being wirelessly connected to the personal device.

According to the proposed method, the variation in the electric field can comprise the calculation of a derivative obtained from a consecutive sequence of electric field values acquired by the personal device, the alarm means being able to be controlled depending on said calculation of a derivative and on said measured movement of the personal device.

### Brief Description of the Drawings

The foregoing and other advantages and features will be better understood based on the following detailed description of several embodiments in reference to the attached drawings which must be interpreted in an illustrative and non-limiting manner, in which:
Figure 1 shows an example of the personal protective device proposed by the present invention according to one embodiment.
Figure 2 schematically shows the different components housed in the housing of the personal protective proposed device according to a preferred embodiment.

### Detailed Description of the Invention and Embodiments

The present invention provides a personal protective device 10, referred to in this description as an element for detecting electric fields and/or voltage, as well as a method by means of using the mentioned personal protective device 10, said device being for individual use by a user, located away from live electrical equipment or systems, omni-directional and providing a safety indication of the detected electric fields and/or voltage.

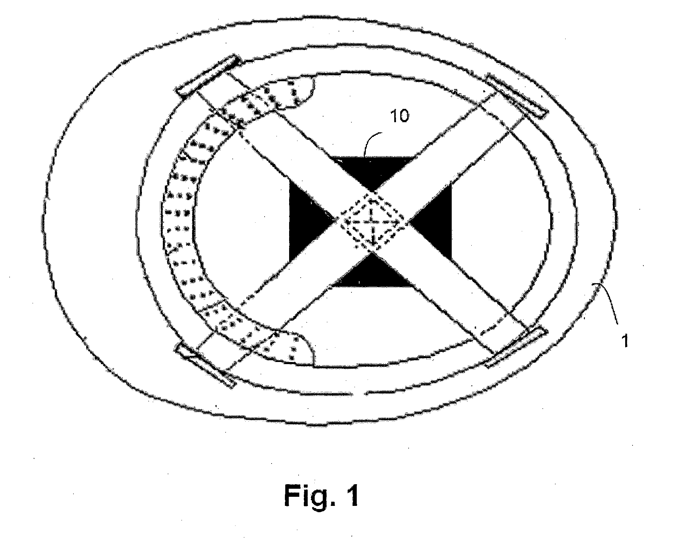

In reference to Figure 1, said figure shows one embodiment of the proposed personal protective device 10, in this case incorporated in a protective helmet 1.

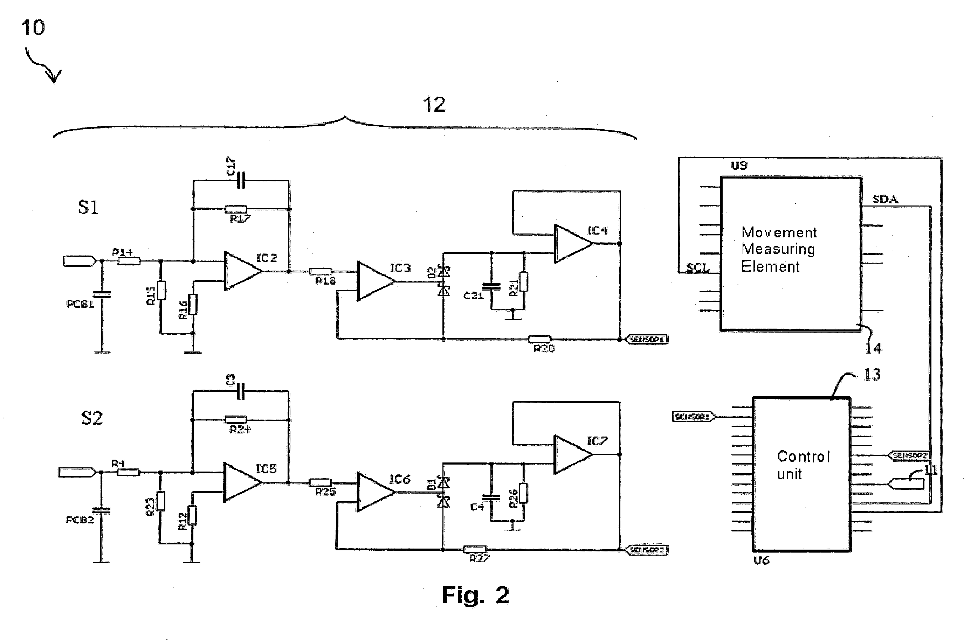

The personal protective device 10 in this particular case comprises a housing holding therein an electric circuit including (see Figure 2) acquisition means 12 (alternating current or AC means) for acquiring electric field measuring signals (AC signals) responsive to the variation in strength of a detected electric field (and/or detected voltage) and alarm means or alarm device 11 (visual, acoustic, vibrating, etc.) generating a warning signal when the strength of the detected electric field exceeds a specific threshold value. Likewise, the personal protective device 10 includes a movement measuring element 14 for measuring the movement of the personal protective device 10, for example, an accelerometer (without this being limiting since any element capable of measuring movement can be used), and a control unit 13, such as a microcontroller, connected to the electric circuit, for processing the acquired electric field measuring signals and calculating, preferably by means of computing the derivative of the consecutive sequence of the acquired/measured electric field values, the variation experienced by the personal protective device 10 with respect to the detected electric field (and/or detected voltage).

The personal protective device 10 allows, when the user approaches an electric field having a high strength comprised between 10 kV - 66 kV, for example, and goes over a threshold distance, about 1 meter for 10 kV and 3 meters for 66 kV, the personal protective device 10, by means of the alarm means 11, maintaining a warning signal (visual, acoustic, vibrating, etc.) to indicate to the user that (s)he is in a danger zone. In one embodiment, the mentioned warning signal does not stop until the user moves away from the voltage source. Alternatively, in another embodiment the warning signal is kept active only for a specific time period. In this last case, the warning signal is repeated if the user has not moved away from the voltage source, i.e., if the movement measuring element 14 has not detected a variation in the movement of the user, and accordingly of the personal protective device 10.

Now in reference to Figure 2, said figure shows a preferred embodiment of the components housed in the housing of the personal protective device 10. As can be seen, the mentioned acquisition means 12 in this case consist of two capacitive sensors S1, S2 connected in parallel and acting as antennas, each of them including a capacitor PCB1, PCB2 and a charge amplifier IC2, IC5 and a signal conditioner IC3-IC4, IC6-IC7. This dual configuration (use of two capacitive sensors in parallel) firstly allows broadening the range of use of the personal protective device 10, and secondly allows detecting situations in which a strong electric field due to a far away source masks a weaker electric field due to a nearby source, and it is this weaker electric field that actually generates a dangerous situation.

The location of the two capacitive sensors S1, S2, sized for electric field levels occurring in operations in medium- and high-voltage electrical installations allows capturing electric fields affecting the user generated both by nearby and far away sources, regardless of the direction of origin. Therefore, the omni-directionality feature is supported in the personal protective device 10.

Likewise, processing of the data or electric field measuring signals by the control unit 13 allows calculating not only the variation in the electric field experienced by the personal protective device 10, but also the distance of the source generating it and the voltage level of said source.

Continuing with the explanation of Figure 2, the first sensor S1 includes a capacitor PCB1 and a charge amplifier (operational amplifier) IC2. In this operational amplifier IC2, by means of the negative feedback provided by C17, the charge induced in capacitor PCB1 due to the external electric field is obtained as voltage at the IC2 output (in low impedance) and can be analogically processed by the peak detector formed by IC3 and IC4 and diodes D2.

The capacitor C21 maintains the peak value (positive maximum) of the AC signal of the IC2 output throughout successive cycles. On the other hand, the resistor R21 allows the capacitor C21 to discharge and to therefore follow the new IC2 output voltage maximum if the amplitude of the AC signal decreases (due to the decrease in the external field).

The time constant resulting from the configuration of the resistor R21 in parallel with the capacitor C21 is about 1 second, so the response to the decrease in electric field is slow and the system responds smoothly to variations in the external electric field.

Now with reference to the second sensor S2, this second sensor S2 is similar to the first sensor S1, with the particularity that the impedance values of the capacitors C17 and C3 are different, the capacity of C3 being less than the capacity of C17. By modifying the capacity of C17, in this case reducing it, the charge and discharge of the capacitor will be quicker. This situation is necessary for detecting high electric fields, since with more electric field, the circuit of the first sensor S1 will behave like the circuit of the second sensor S2, thereby preventing it from becoming saturated and preventing the signal from being non-interpretable.

In yet another embodiment, not illustrated in this case, which is simpler although not as effective when detecting electric fields that are extremely high or have very small dimensions, but likewise usable, the mentioned acquisition means 12 only consist of a capacitive sensor and a charge amplifier. The operation with a single capacitive sensor is the same as the operation described above for two capacitive sensors.

This last configuration with a single sensor is not the most desired configuration when the electric field is very large or even very small, since the electric field can saturate the charge amplifier and the acquisition means would then always provide the same readings, variations not occurring as a result. For this reason, configuration with two capacitive sensors S1, S2 is more effective and reliable, and therefore more recommendable, since the inclusion of an additional capacitive sensor allows changing, by means of capacitor C3 or C17, the gain value of the operational amplifier and making the gain larger or smaller, as appropriate.

The proposed personal protective device 10 is preferably powered by cells or batteries which can be included in the housing itself.

A person skilled in the art may introduce variations and modifications to the embodiments that have been described without departing from the scope of the invention as it is defined in the attached claims.

## Claims

1. A personal protective device (10) for detecting electric fields and/or voltage, used as a safety element against electrical hazards, which comprises:
- a housing holding an electric circuit provided for being incorporated on a user to be protected; and
- said electric circuit including:
- acquisition means (12) for acquiring electric field measuring signals responsive to the variation in strength of a detected electric field; and
- alarm means (11) whereby a warning signal is generated,
**characterized in that** it further comprises:
- a movement measuring element (14) for measuring the movement of said personal protective device (10); and
- a control unit (13) connected to said electric circuit, which performs processing of the acquired electric field measuring signals and calculation of the variation experienced by the personal protective device (10) with respect to said detected electric field.

2. The device according to claim 1, **characterized in that** said acquisition means (12) for acquiring electric field measuring signals include at least one capacitive sensor and at least one charge amplifier for conditioning the acquired electric field measuring signals.

3. The device according to claim 1, **characterized in that** the acquisition means (12) for acquiring electric field measuring signals include at least two capacitive sensors (S1, S2) acting in parallel, each including at least one charge amplifier (IC2, IC5) and a conditioning step (IC3-IC4, IC6-IC7) of the acquired electric field measuring signals.

4. The device according to any one of the preceding claims, **characterized in that** said control unit (13) comprises a microcontroller receiving information about the movement of the personal protective device and controlling the actuation of said alarm means (11) depending on the variation in the electric field and on said movement.

5. The device according to any one of the preceding claims, **characterized in that** the alarm means (11) comprise an acoustic and/or visual and/or vibrating element and means for the cancellation thereof.

6. The device according to claim 1, **characterized in that** said movement measuring element (14) comprises at least one accelerometer.

7. The device according to claim 2 or 3, **characterized in that** said capacitive sensor or sensors is/are sized to be responsive to different electric field values.

8. The device according to any one of the preceding claims, **characterized in that** the housing holding the electric circuit is incorporated in a protective helmet (1) of the user.

9. A method for detecting electric fields and/or voltage which comprises using a personal protective device (10) as a safety element against electrical hazards, wherein said personal protective device (10) comprises an electric circuit including acquisition means (12) for acquiring electric field measuring signals responsive to the variation in strength of a detected electric field, and alarm means whereby a warning signal is generated, **characterized in that** it comprises calculating a variation in the electric field experienced by the personal protective device (10) incorporated on a user, and contemporaneously measuring any movement of the personal protective device (10), as a result of a movement of said user.

10. The method according to claim 9, **characterized in that** said calculation of the variation in the electric field is performed continuously.

11. The method according to claim 9 or 10, **characterized in that** the calculation of the variation in the electric field and the measurement of movement are performed in the personal protective device (10) itself.

12. The method according to claim 9 or 10, **characterized in that** the variation in the electric field comprises the calculation of a derivative obtained from a consecutive sequence of electric field values acquired by the personal protective device (10).

13. The method according to claim 12, **characterized in that** it comprises generating the warning signal depending on said calculation of a derivative and on the measured movement of the personal protective device (10).
